# FASCICULE DE BREVET EUROPEEN

(11) **EP 2 223 377 B1**
(45) Date de publication et mention de la délivrance du brevet: **29.05.2013**
(21) Numéro de dépôt: 08862057.0
(22) Date de dépôt: 15.12.2008
(51) Int. Cl.: H01P 5/12, H03F 3/60

(54) **DISPOSITIF D'AMPLIFICATION DE PUISSANCE RADIALE A COMPENSATION DE DISPERSION DE PHASE DES VOIES AMPLIFICATRICES**
Radiale Vorrichtung zur Leistungsverstärkung mit Phasensdispersionausgleich der Verstärkungswege
RADIAL POWER AMPLIFICATION DEVICE WITH PHASE DISPERSION COMPENSATION OF THE AMPLIFICATION PATHS

(30) Priorité: 18.12.2007 FR 0708848
(43) Date de publication de la demande: 01.09.2010
(73) Titulaire: THALES, 92200 Neuilly-sur-Seine (FR)
(72) Inventeur: FRAYSSE, Jean-Philippe, F-31200 Toulouse (FR); DENOUAL, Jean-Michel, F-29190 Pleyben (FR); PEDEN, Alain, F-29200 Brest (FR)
(74) Mandataire: Esselin, Sophie
(86) Numéro de dépôt international: PCT/EP2008/067546
(87) Numéro de publication internationale: WO 2009/077501

(56) Documents cités:
- WO-A-2006/096771
- US-A- 4 291 278
- US-A- 5 218 322
- BELOHOUBEK E ET AL: "30-WAY RADIAL POWER COMBINER FOR MINIATURE GAAS FET POWER AMPLIFIERS" INTERNATIONAL MICROWAVE SYMPOSIUM DIGEST. BALTIMORE, MARYLAND, JUNE 2 19860602; 19860602 - 19860604 NEW YORK, IEEE, US, 2 juin 1986 (1986-06-02), pages 515-518, XP002181723

## Description

La présente invention concerne le domaine des amplificateurs hyperfréquences à semi-conducteurs et plus particulièrement les systèmes de combinaison de puissance. Parmi les différentes techniques de combinaisons, le domaine de l'invention se situe dans les systèmes de combinaisons de puissance radiales.

La puissance de sortie des éléments semi-conducteurs diminuant avec l'augmentation de la fréquence de fonctionnement, il est nécessaire de combiner plusieurs amplificateurs semi-conducteurs élémentaires pour atteindre les puissances de sortie requises par certaines applications telles que les émetteurs de télémesure d'instruments haut-débit des satellites par exemple.

Aujourd'hui, les systèmes de combinaison de puissance utilisés dans le domaine spatial ne sont pas adaptés pour combiner réellement efficacement plus de 4 amplificateurs élémentaires aux fréquences millimétriques. Une conséquence de cette limitation conduit parfois à concevoir des composants à semi-conducteurs en privilégiant la puissance de sortie au détriment du rendement en puissance ajoutée et de la criticité des conceptions.

Par ailleurs, ces combinaisons sont parfois insuffisantes et limitatives pour obtenir les puissances de sortie des SSPA, signifiant « Solid State Power Amplifier» dans la terminologie anglo-saxonne, requises pour répondre aux réels besoins des applications.

Les systèmes de combinaison de puissance comportent généralement un diviseur, un amplificateur et un combineur permettant à partir d'un signal d'entrée de délivrer un signal de sortie amplifié. Ces systèmes comportent généralement des transitions permettant de changer de structures de propagation telles que d'une structure planaire vers un guide d'onde rectangulaire ou un guide d'onde coaxial par exemple.

Aujourd'hui, les principales technologies de combinaisons de puissance se déclinent selon une première catégorie de combinaison de puissance dite arborescente, une seconde catégorie de combinaison de puissance dite spatiale et une troisième catégorie de combinaison de puissance dite radiale.

Les techniques de combinaison arborescentes planaires permettent de combiner efficacement deux ou quatre amplificateurs. Toutefois, ces techniques ne sont pas adaptées pour combiner un grand nombre d'amplificateurs car l'augmentation du nombre d'étages de combinaison et l'allongement des lignes de liaison entre les additionneurs du combineur conduisent à dégrader très sensiblement le signal par des pertes de combinaison.

Afin de minimiser ces pertes de combinaison, des guides d'onde métalliques peuvent être utilisés à la place des lignes de propagation planaires. Dans ce cas de figure, il est alors nécessaire de rajouter entre le combineur et les amplificateurs élémentaires des transitions afin d'assurer la propagation des signaux entre les lignes planaires des amplificateurs élémentaires et les guides d'onde métalliques du combineur. Le rajout de ces transitions et surtout la taille des guides d'onde métalliques utilisés conduit à un encombrement important de ce type de combineur. Il n'est donc pas adapté pour combiner un grand nombre d'amplificateurs.

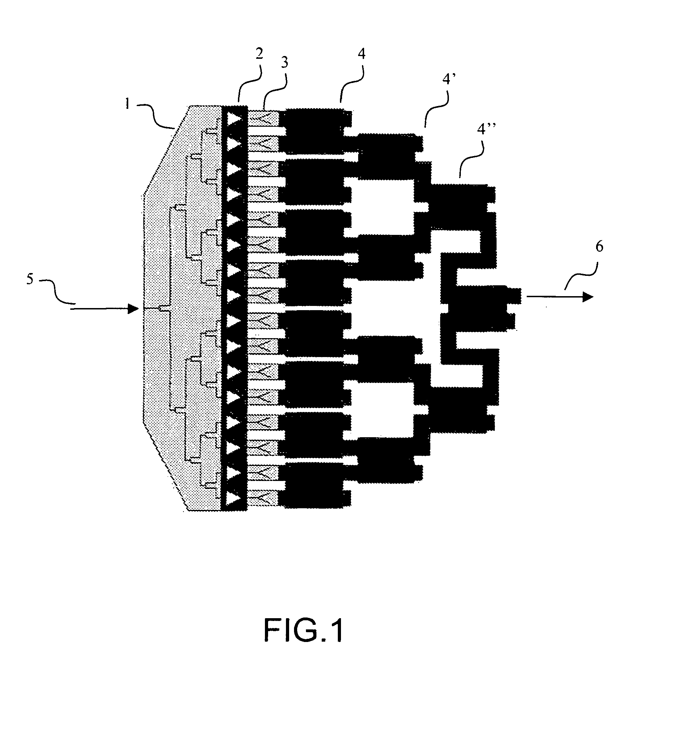

Les combinaisons arborescentes telles que représentées dans la figure 1 comprennent généralement un diviseur 1 permettant de diviser un signal d'entrée 5 dans différentes voies amplificatrices 2. Les différents signaux amplifiés sortant des voies amplificatrices peuvent être propagés et combinés dans différents étages d'additionneur binaire en guide d'onde rectangulaire 4, 4', 4" à partir d'une transition 3. Un signal amplifié et combiné 6 peut alors être traité en aval.

Les techniques de combinaisons spatiales telles que la solution développée dans le brevet US5736908 sont caractérisées en ce que le dispositif d'amplification comprend plusieurs voies amplificatrices, généralement sous forme de plateaux, se superposant. Le signal d'entrée se répartit sur les voies amplificatrices grâce à la distribution spatiale de l'énergie du signal et se re-combine en sortie une fois amplifié suivant le même principe. Ces techniques présentent plusieurs inconvénients.

Le premier inconvénient résulte d'une combinaison de nombreux amplificateurs avec cette technique. Il est alors nécessaire d'ajouter des dispositifs supplémentaires pour pouvoir exciter et combiner uniformément toutes les voies amplificatrices. Ces dispositifs supplémentaires rajoutant des pertes, l'efficacité de combinaison de ce type de combineur est dégradée.

Un second inconvénient est la difficulté d'obtenir une évacuation efficace de la puissance dissipée par les différentes voies amplificatrices superposées. Ceci a pour conséquence, avec ce type de technique de combinaison, lorsque de nombreux amplificateurs sont combinés, de rendre difficile le respect des contraintes imposées par le domaine spatial sur les températures maximales de jonction des composants à semi-conducteurs, ces dernières ne devant pas être dépassées.

En dernier lieu, un inconvénient est la relative dépendance des voies amplificatrices, une panne survenant dans l'une des voies amplificatrices, celle-ci peut perturber fortement le fonctionnement général du dispositif d'amplification.

Les techniques de combinaisons radiales telles que les solutions proposées dans les brevets US4700145, US4641106 et US4931747 sont caractérisées en ce que le dispositif d'amplification comprend plusieurs voies amplificatrices, chacune se connectant aux extrémités de deux guides d'onde radiaux, les extrémités étant situées entre le diviseur et le combineur, les deux guides d'onde radiaux étant superposés. Cette connexion permet d'amplifier un premier signal provenant d'un des accès du premier guide d'onde radial et de le réinjecter dans un des accès du second guide d'onde radial de manière à ce qu'il se re-combine avec les autres signaux provenant des autres accès du guide d'onde radial du combineur.

Ces techniques présentent de nombreux avantages notamment l'encombrement réduit du dispositif d'amplification par rapport à une technique de combinaison à structure arborescente avec des guides d'onde rectangulaires. Par ailleurs, un autre avantage est la possibilité d'améliorer le contrôle de la diminution de la puissance de sortie induite par la panne d'une ou plusieurs voies amplificatrices en améliorant l'isolation entre les voies amplificatrices grâce à des matériaux absorbants ou des moyens dissipatifs placés au niveau des parois des guides d'onde radiaux.

En outre, les dispositifs d'amplification radiaux permettent de combiner plusieurs amplificateurs élémentaires en une seule étape. Les pertes de combinaison sont donc réduites par rapport aux techniques de combinaison arborescentes.

En revanche, une limitation actuelle de ces solutions provient du fait qu'il n'existe pas de système simple et efficace pour compenser la dispersion de phase des différentes voies amplificatrices combinées lors de la recombinaison du signal de sortie. Cet inconvénient nécessite d'effectuer un tri des voies amplificatrices sur la phase du coefficient de transmission ou nécessite de rajouter des déphaseurs variables sur les voies amplificatrices pour compenser la dispersion de phase des voies amplificatrices. Cette dernière solution est complexe à mettre en oeuvre, encombrante, introduit de nouvelles pertes et consomme éventuellement une puissance supplémentaire.

Un but de l'invention est de pallier les inconvénients précités.

L'invention propose un dispositif d'amplification radial comprenant des moyens de réglage du positionnement des voies amplificatrices de manière à ajuster le déphasage des différentes voies, ce qui permet de combiner un signal de sortie en phase.

Avantageusement, le système de combinaison de puissance radiale à compensation de dispersion de phase dans le domaine des hyperfréquences comprend :
■ un premier guide d'onde radial, appelé diviseur radial, ayant une entrée en son centre et une pluralité de sorties en périphérie, chacune des sorties étant un guide d'onde métallique, le premier guide d'onde radial permettant de diviser un signal d'entrée en plusieurs signaux de sortie ;
■ un second guide d'onde radial, appelé combineur radial, superposé au diviseur radial ayant une sortie en son centre et une pluralité d'entrées en périphérie, chacune des entrées étant un guide d'onde métallique, le second guide d'onde radial permettant de combiner une pluralité de signaux d'entrée en un signal de sortie ;

■ une première transition d'entrée émettant un premier signal dans le diviseur radial ;
■ une seconde transition de sortie captant le premier signal amplifié vers la sortie du combineur radial ;
■ une pluralité de voies amplificatrices, chacune comprenant :
   o une troisième transition d'entrée apte à coopérer avec l'un des guides d'onde métalliques du diviseur radial et ;
   o une quatrième transition de sortie apte à coopérer avec l'un des guides d'onde métalliques du combineur radial et ;
   o au moins un amplificateur solidaire de la troisième et quatrième transition.

Avantageusement, le système comprend des moyens de réglages (29) du positionnement d'au moins une voie amplificatrice dans les guides d'onde métalliques.

Avantageusement, les moyens de réglages comprennent un jeu de cales.

Avantageusement, chaque voie amplificatrice comprend des moyens de fixations permettant de fixer chaque voie amplificatrice au combineur et au diviseur avec une cale.

Avantageusement, le jeu de cales contribue au transfert thermique entre les voies amplificatrices et les guides d'onde radiaux.

Avantageusement, des coquilles revêtent les voies amplificatrices et favorisent les échanges thermiques entre les amplificateurs et l'extérieur du système.

Avantageusement, les guides d'onde métalliques des sorties du diviseur et des entrées du combineur sont droits de manière à ce que la connexion des voies amplificatrices est réalisée dans l'axe radial.

Avantageusement, les guides d'onde métalliques des sorties du diviseur et des entrées du combineur sont coudés de manière à ce que la connexion des voies amplificatrices est réalisée perpendiculairement à l'axe radial.

Avantageusement, le diviseur radial et le combineur radial comprennent des matériaux absorbants ou des moyens dissipatifs assurant l'isolation entre les voies.

Avantageusement, les guides d'onde métalliques en périphérie des deux guides d'ondes radiaux sont des guides d'onde rectangulaires.

Avantageusement, l'entrée du diviseur et/ou la sortie du combineur sont des guides d'onde cylindriques.

Avantageusement, l'entrée du diviseur et/ou la sortie du combineur sont des guides d'onde coaxiaux.

Avantageusement, au moins une transition comporte une âme centrale en contact avec la partie inférieure d'un guide d'onde radial.

Avantageusement, au moins un accès d'un guide d'onde coaxial centré sur le guide d'onde radial est destiné à recevoir un connecteur coaxial (28), une bague de centrage, une âme centrale et en ce que cet accès se prolonge en partie dans le guide d'onde radial par un conducteur extérieur (101) en forme de cône directement usiné dans le capot supérieur.

Avantageusement, la transition entre le mode de propagation en guide d'onde rectangulaire et le mode de propagation en micro-ruban comprend :
■ des métallisations dont le profil est en cosinus avec une pente nulle à l'extrémité de la transition côté guide d'onde rectangulaire et ;
■ un substrat découpé selon le profil en cosinus des métallisations de manière à minimiser le coefficient de réflexion de la transition.

D'autres caractéristiques et avantages de l'invention apparaîtront à l'aide de la description qui suit, faite en regard des dessins annexés qui représentent :
- la figure 1 : un dispositif d'amplification à structure arborescente selon l'art antérieur ;
- la figure 2A : une représentation d'un dispositif d'amplification radial ;
- la figure 2B : une représentation d'un dispositif d'amplification radial comportant un jeu de cales.
- la figure 2C : une représentation d'un dispositif d'amplification radial coudé comportant un jeu de cales.
- la figure 3A : une vue de dessus d'un dispositif d'amplification radial selon l'invention ;
- la figure 3B : une vue en coupe du dispositif d'amplification radial de la figure 3A ;
- La figure 4A : une première variante de réalisation de la voie amplificatrice et des moyens de réglage du positionnement ;
- La figure 4B : une seconde variante de réalisation de la voie amplificatrice et des moyens de réglage du positionnement ;
- La figure 4C : une troisième variante de réalisation de la voie amplificatrice et des moyens de réglage du positionnement ;
- La figure 5A : une vue en coupe d'un exemple de transition entre un guide d'onde coaxial et un guide d'onde radial ;
- La figure 5B : une vue en coupe et une vue de dessus d'un cas de réalisation d'une transition entre un guide d'onde coaxial et un guide d'onde radial ;
- Les figures 6A et 6B : un cas de réalisation d'une transition entre un guide d'onde rectangulaire et une ligne micro-ruban ;
- La figure 6C : un cas de réalisation d'une transition comportant plusieurs circuits pour réaliser une transition entre un guide d'onde rectangulaire et des lignes micro-rubans ;

Dans la description qui suit, on appelle « transition » tout dispositif qui permet le passage d'une onde électromagnétique d'une structure de propagation vers une autre avec le minimum de pertes de transmission comme par exemple, une ligne coaxiale vers un guide d'onde radial, ou un guide d'onde rectangulaire vers une ou plusieurs lignes planaires de type micro-ruban, coplanaire, fente, ou tout autre support.

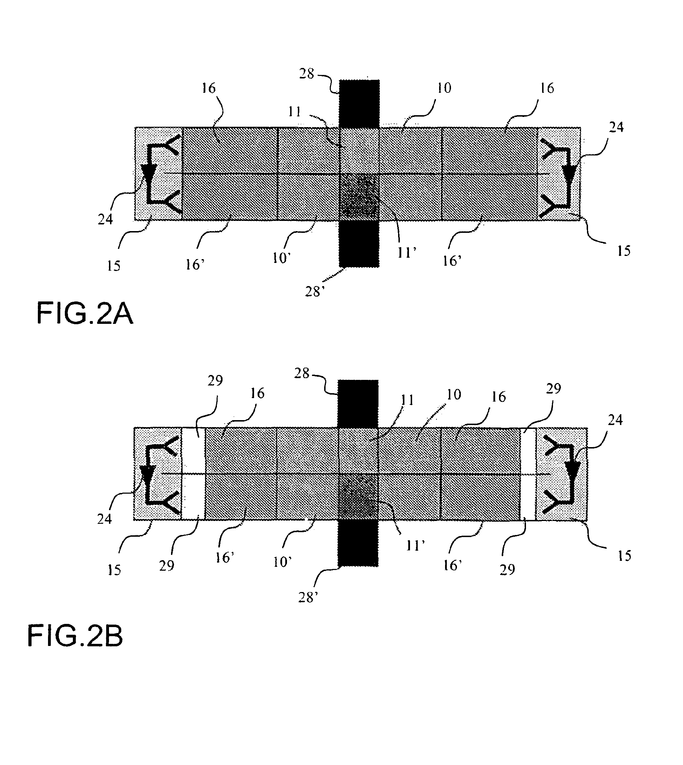

Les figures 2A et 2B illustrent une représentation sous forme de blocs dans une coupe respectivement d'un dispositif de l'art antérieur et d'un dispositif d'amplification selon l'invention.

Le dispositif comprend un diviseur comportant un premier guide d'onde radial 10 dans lequel un signal d'entrée pénètre par l'intermédiaire d'une transition 11, la transition 11 assurant la propagation du signal entre un accès 28, de type guide d'onde coaxial, guide d'onde cylindrique ou guide d'onde rectangulaire par exemple, et le guide d'onde radial 10.

Le diviseur du dispositif d'amplification comprend, dans l'exemple de la figure 2B, un guide d'onde radial 10 avec des accès en guides d'onde rectangulaires 16 en périphérie. Les signaux divisés se propagent dans chacun des guides d'onde rectangulaires 16 pour atteindre les transitions d'entrées des voies amplificatrices 15 enfichées ou connectées selon les modes de réalisation dans les guides d'onde rectangulaires pour y être fixées. Les voies amplificatrices 15 permettent de capter les signaux provenant des guides d'onde rectangulaires 16, de les amplifier grâce à un amplificateur 24, et de les émettre dans des guides d'onde rectangulaires 16' afin que les signaux se re-combinent entre eux dans le combineur 10'. Les signaux combinés sont transmis vers l'extérieur du dispositif par l'intermédiaire d'une transition 11' assurant la propagation du signal entre le guide d'onde radial 10' et un second accès 28', de type guide d'onde coaxial, guide d'onde cylindrique ou guide d'onde rectangulaire par exemple.

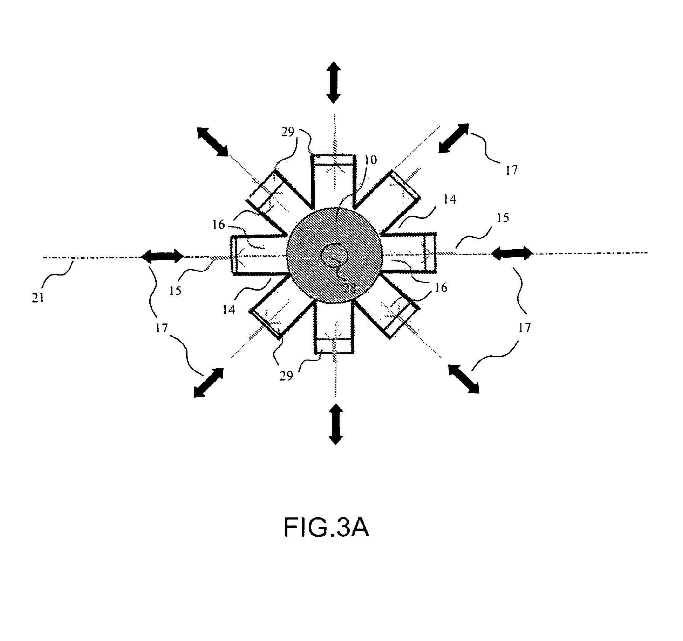

Les voies amplificatrices 15 peuvent être enfichées ou fixées par l'intermédiaire d'un dispositif de fixation aux guides d'onde rectangulaires 16 et 16' selon un sens 17 précisé sur la figure 3A.

Par exemple, des cales 29 peuvent être ajoutées, comme illustrées figure 2B, entre les voies amplificatrices 15 et les guides d'onde rectangulaires 16, 16'. Celles-ci peuvent être avantageusement de différentes épaisseurs selon les voies des guides d'onde rectangulaires 16, 16' pour s'adapter au déphasage propre de chaque voie amplificatrice 15.

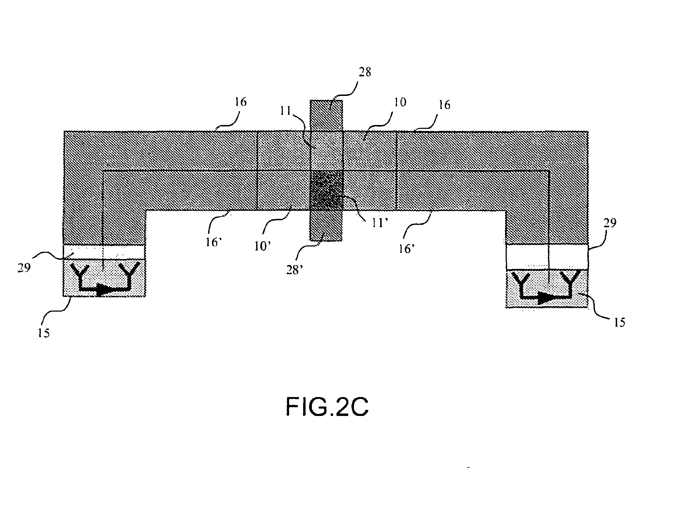

Dans un autre mode de réalisation représenté figure 2C, les guides d'onde rectangulaires 16, 16' peuvent être coudés, par exemple à 90° de manière à ce que la direction de connexion des voies amplificatrices 15 s'effectuent selon la direction des axes des transitions 11, 11'.

Par la suite, on appellera voie amplificatrice, une voie comprenant au moins une transition d'émission, une transition de réception et au moins un amplificateur.

L'invention s'applique plus généralement, au-delà du mode de réalisation décrit, à des accès en guides d'onde métalliques en périphérie du guide d'onde radial.

La figure 3A représente une vue de dessus d'un dispositif selon l'invention comprenant un diviseur comportant un premier guide d'onde radial 10 par lequel un signal d'entrée pénètre par l'intermédiaire d'une transition 11 (non représentée sur cette figure) assurant la transmission d'un signal provenant d'un accès 28.

Le diviseur du dispositif d'amplification comprend, dans l'exemple de la figure 3A, un guide d'onde radial 10 avec des accès en guides d'onde rectangulaires 16 en périphérie. Dans ce mode de réalisation, le dispositif selon l'invention dispose de huit guides d'onde rectangulaires disposés symétriquement en périphérie du guide d'onde radial 10. Les signaux divisés se propagent dans chacun des guides d'onde rectangulaires pour atteindre les transitions d'entrée des voies amplificatrices 15 enfichées et connectées dans les guides d'onde rectangulaires.

Le dispositif d'amplification selon l'invention permet de disposer de moyens de réglage 29 de la position de chacune des transitions dans les guides d'onde rectangulaires 16. Ces moyens de réglages 29 dans un mode de réalisation représenté dans la figure 3A sont des jeux de cales qui peuvent être réalisés par des guides d'onde rectangulaires d'adaptation 29.

Avantageusement, la partie 14 formant un angle à l'intersection de deux guides d'onde rectangulaires 16 permet aux signaux de se répartir intégralement dans les différents accès en guides d'onde métalliques.

Le dispositif selon l'invention comprend un combineur superposé au diviseur comportant un guide d'onde radial avec des accès en guides d'onde rectangulaires, mais il n'est pas représenté sur la vue de dessus de la figure 3A.

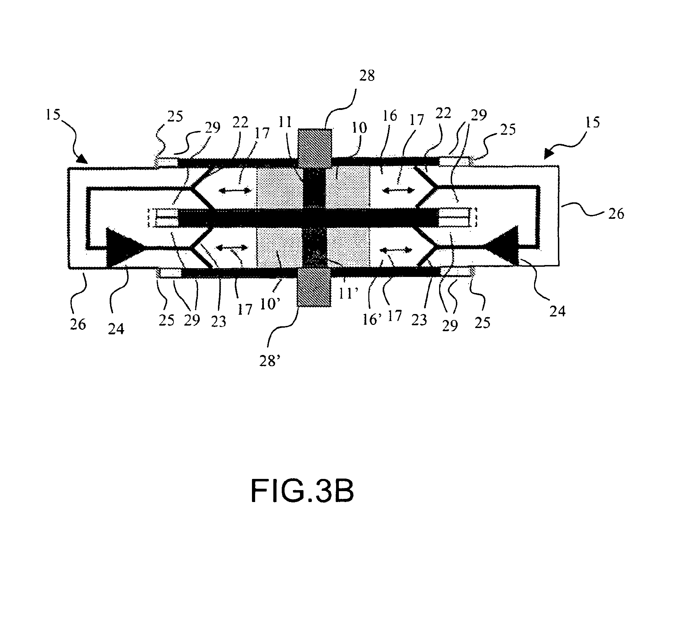

La figure 3B représente le dispositif d'amplification de la figure 3A dans le plan de coupe selon l'axe 21. Ce dernier comprend deux guides d'onde radiaux 10, 10' superposés qui coopèrent avec respectivement des guides d'onde rectangulaires 16 et 16' disposés en périphérie.

Une transition 11 émet le signal provenant de l'accès 28 dans le guide d'onde radial 10. L'accès 28 peut être un guide d'onde cylindrique, un guide d'onde coaxial ou encore un guide d'onde rectangulaire selon les modes de réalisation de l'invention. La géométrie du guide d'onde radial 10 et celle des guides d'onde rectangulaires 16 permettent de répartir le signal émis dans chacun des guides d'onde rectangulaires 16.

Le dispositif comprend également les voies amplificatrices 15 qui sont enfichées ou connectées et fixées à l'aide de moyens de fixation selon les modes de réalisation. Chacune des voies amplificatrices 15 comprend une transition de réception 22 assurant la propagation du signal d'un guide d'onde rectangulaire dans une ligne de propagation planaire, de type micro-ruban par exemple. En outre, chaque voie amplificatrice 15 comprend au moins un amplificateur 24 et une transition d'émission 23 du signal amplifié. De la même façon que la transition de réception, la transition d'émission 23 peut être une simple transition d'une ligne de propagation planaire, de type micro-ruban par exemple, dans un guide d'onde rectangulaire.

Le combineur comprend un guide d'onde radial 10', qui peut être appelé combineur radial, avec des accès en guides d'onde rectangulaires en périphérie. Le guide d'onde radial 10' reçoit chaque signal provenant de chaque voie amplificatrice 15 qui se propage par l'intermédiaire de guides d'onde rectangulaires 16'. Le guide d'onde radial 10' permet de transmettre les signaux de sortie combinés à l'accès 28' via la transition 11'.

Le principal avantage de la solution de l'invention est de permettre d'ajuster les phases des différents signaux provenant des guides d'onde rectangulaires 16' qui se re-combinent dans le guide d'onde radial 10'. Cet ajustement est effectué à l'aide de moyens de réglage de l'enfoncement des voies amplificatrices 15 dans les guides d'onde rectangulaires 16 et 16'.

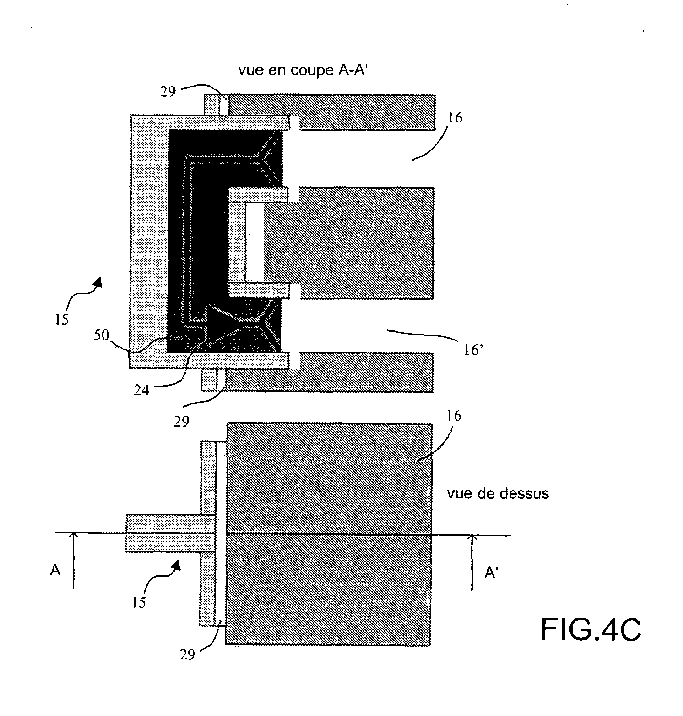

Dans une variante de réalisation, ces moyens peuvent être des cales 29 de butées coopérant avec les guides d'onde rectangulaires 16 et 16' sous forme de guide d'onde d'adaptation rectangulaire, tel que représenté figure 4C.

Les cales peuvent être choisies en fonction du déphasage introduit par les voies amplificatrices 15.

Un autre avantage est de pouvoir tester les voies amplificatrices 15 séparément dans deux guides d'onde rectangulaires superposés de manière à connaître leurs caractéristiques avant leur montage dans le dispositif d'amplification.

La mesure du déphasage introduit par les voies amplificatrices permet de déterminer le positionnement de chaque voie amplificatrice dans les guides d'onde rectangulaires 16, 16' de manière à ce que toutes les voies amplificatrices se re-combinent en phase.

Une coquille 26 peut avantageusement revêtir la voie amplificatrice ainsi que des moyens de fixation 25 représentés par une butée sur la figure 3B.

Les amplificateurs 24 peuvent être avantageusement en contact avec la coquille 26 pour favoriser les échanges thermiques entre les amplificateurs et l'extérieur du système.

Le dispositif selon l'invention, dans d'autres modes de réalisation, permet d'augmenter le nombre d'amplificateurs combinés. Trois solutions peuvent être employées simultanément ou indépendamment.

La première solution consiste à augmenter le nombre d'accès en guides d'onde rectangulaires. La seconde solution est d'augmenter le nombre d'amplificateurs par voies amplificatrices. Enfin une troisième solution consiste à augmenter le nombre de voies amplificatrices enfichables dans chaque guide d'onde rectangulaire.

Le dispositif selon l'invention propose d'améliorer l'isolation entre les voies du combineur et du diviseur en plaçant avantageusement dans le combineur et le diviseur des matériaux absorbants ou des moyens dissipatifs, tel que décrit par exemple dans le brevet US4263568. Cette amélioration permet de rendre plus indépendantes les voies amplificatrices.

Les avantages du dispositif selon l'invention et notamment du mode de réalisation exposé est qu'il présente une faible dispersion de phase des parties passives, qu'il introduit de faibles pertes de combinaison et qu'il permet des plages d'utilisation pouvant s'étendre des bandes centimétriques aux bandes millimétriques.

Par ailleurs, des avantages résident en ce que les voies amplificatrices sont facilement démontables, qu'elles puissent comprendre à la fois l'amplificateur et les transitions et enfin qu'elles puissent être caractérisées facilement, notamment par le paramètre intrinsèque du déphasage introduit par la voie amplificatrice.

En outre, la compacité du dispositif permet de réaliser un assemblage peu encombrant tout en conservant une gestion efficace des contraintes thermiques.

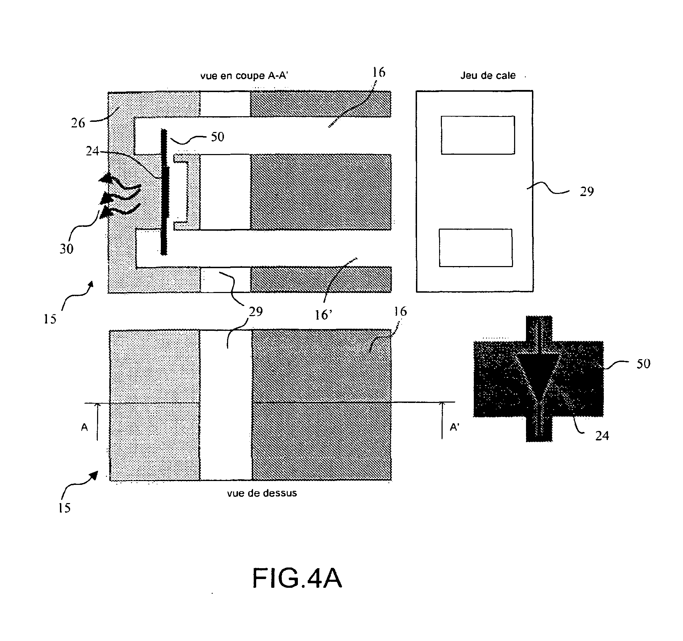

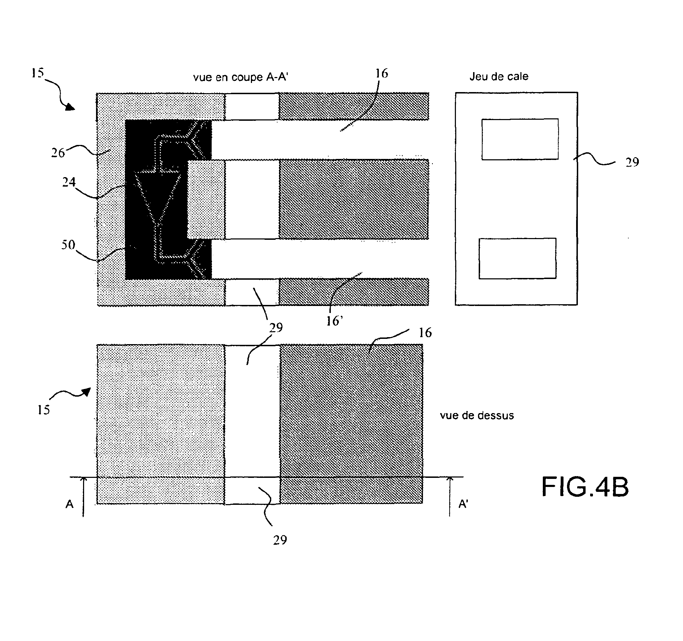

Les figures 4A, 4B et 4C illustrent des variantes de réalisations notamment de la voie amplificatrice 15 permettant d'intégrer l'amplificateur 24 et de réaliser les transitions d'émission et de réception par l'intermédiaire de lignes métalliques sur un substrat 50. Les voies amplificatrices 15 peuvent être connectées aux guides d'onde 16, 16' comme illustré figure 4A et 4B ou enfichées dans les guides d'onde rectangulaires comme illustré figure 4C.

Dans ces variantes de réalisation, les jeux de cales 29 peuvent être de simples cales de butée comme illustrés figure 4C ou encore des guides d'onde rectangulaires d'adaptation tels que représentés figure 4A.

Dans un cas privilégié de réalisation, ces jeux de cale permettent un échange thermique efficace entre les voies amplificatrices et les accès des guides d'onde radiaux aptes à dissiper sur une grande surface la chaleur. En outre, le positionnement des voies amplificatrices en périphérie de la structure permet d'envisager également une évacuation de la puissance dissipée par la périphérie.

La figure 4A illustre l'utilisation avantageuse de la coquille (26) pour favoriser l'échange thermique (30) entre l'amplificateur et l'extérieur du système.

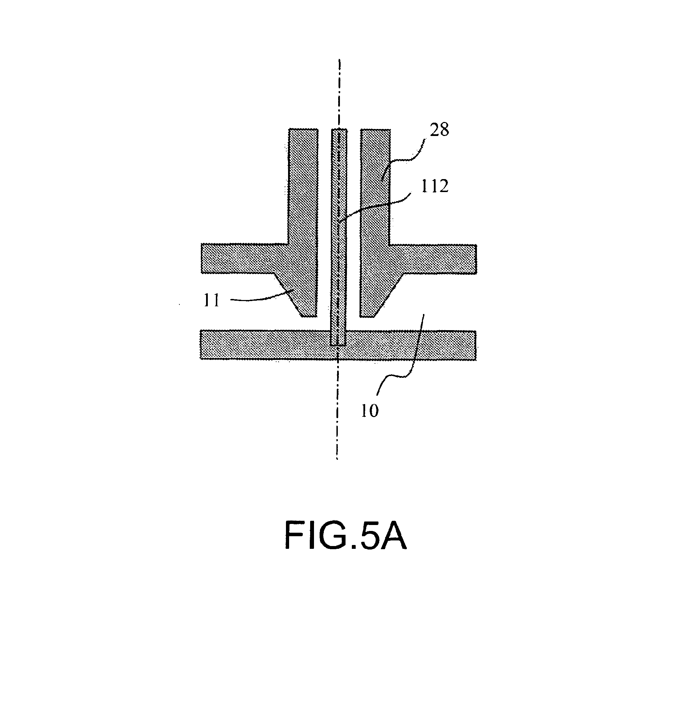

La figure 5A illustre une vue en coupe d'un exemple de transition 11 entre un accès coaxial 28, également appelé connecteur coaxial, et un guide d'onde radial 10.

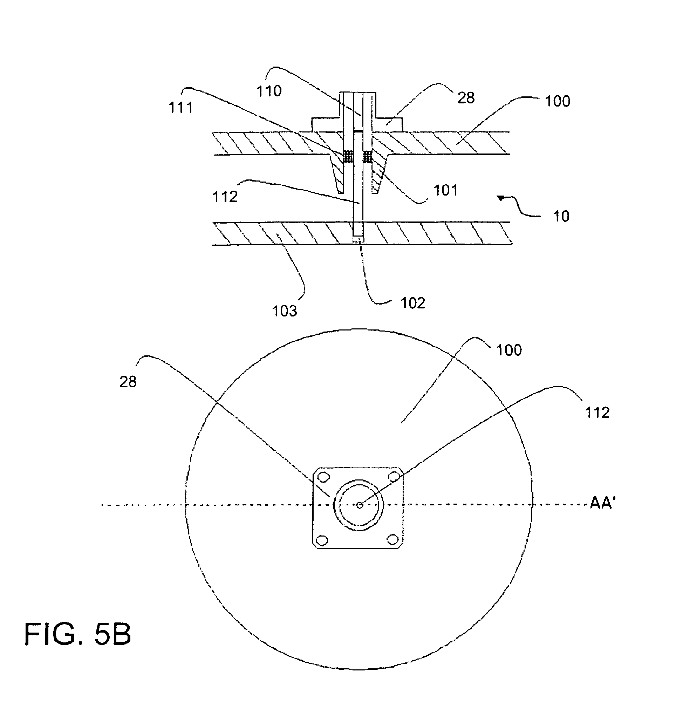

La figure 5B est un exemple de réalisation d'une transition telle que celle de la figure 5A.

La transition entre l'accès coaxial et le guide d'onde radial est composée de deux parties métalliques : un capot supérieur 100 et un capot inférieur 103 qui forment un guide d'onde radial 10. Le guide d'onde coaxial centré sur la structure radiale se prolonge en partie dans le guide d'onde radial 10 par un conducteur extérieur 101 en forme de cône directement usiné dans le capot supérieur 100. Le guide d'onde coaxial ainsi constitué a les mêmes dimensions intérieures que celles du connecteur coaxial 28 fixé sur le capot supérieur 100. L'âme centrale 110 du connecteur coaxial prolongé est réalisée par une tige métallique 112 s'introduisant, d'une part, dans la partie 110, dite femelle, du connecteur coaxial 28 et, d'autre part, dans un réceptacle 102 prévu dans le capot inférieur 103 du guide d'onde radial 10. Le diamètre de la tige métallique 112 doit également être le même que celui de l'âme 110 du connecteur 28. Il n'y a donc pas de changement des dimensions de la partie coaxiale lors du passage du connecteur 28 au guide d'onde coaxial prolongé dans le guide d'onde radial 10. Cette continuité de dimensions permet de garantir des performances optimales en adaptation de la transition.

Le positionnement précis de l'âme au centre de la structure est assuré d'une part par son réceptacle 102 dans le capot inférieur 103 et d'autre part par une bague diélectrique 111 insérée à l'intérieur du cône 101. Toutefois, dans le cas où cette bague est constituée d'un diélectrique dont la permittivité est différente de celle de l'air, du vide ou du matériau contenu dans la transition, des discontinuités dans le diamètre du conducteur extérieur et/ou le diamètre de l'âme centrale du guide d'onde coaxial peuvent être introduites pour compenser cette différence de permittivité.

Le maintien d'une pression verticale suffisante sur la tige métallique 112, appelée également l'âme, pour l'insertion dans la partie femelle 110 du connecteur 28 peut être réalisé en insérant un ressort ou un matériau compressible dans le trou 102 du capot inférieur 103.

Cette transition illustrée figure 5B permet :
■ de simplifier l'usinage de l'âme centrale et d'améliorer la précision des dimensions géométriques, elle permet donc de réduire la désadaptation lors du passage de l'onde du connecteur dans la structure ;
■ d'obtenir une bonne adaptation sur une large bande de fréquences grâce à l'adaptation progressive réalisée par le cône 101 usiné sur le capot supérieur 100 ;
■ de relâcher les contraintes liées à l'usinage d'un profil de forme complexe sur le conducteur extérieur du coaxial grâce à l'utilisation d'un cône en ligne droite ;
■ l'obtention d'une parfaite symétrie de révolution grâce aux différents systèmes de positionnement de l'âme centrale et du connecteur 110 ;
■ de réaliser une transition d'un coaxial vers un guide d'onde radial de n'importe quelle hauteur en ré-optimisant les deux dimensions géométriques du cône, c'est à dire la hauteur et la largeur de la base ;
■ l'obtention d'une bonne tenue en puissance du dispositif, l'âme centrale du coaxial étant en contact avec le fond de la structure (le capot inférieur 103).

L'incorporation de cette transition dans le diviseur et/ou le combineur permet :
■ de relâcher les contraintes liées à l'usinage, les guides d'onde étant usinés dans le capot inférieur 103 et le cône 101 dans la partie supérieure 100 ;
■ de réaliser, avec une transition d'un encombrement réduit du cône 101, l'adaptation entre un coaxial et un guide d'onde radial dont la hauteur correspond à la hauteur des guides d'onde rectangulaires présents sur la périphérie de la structure.

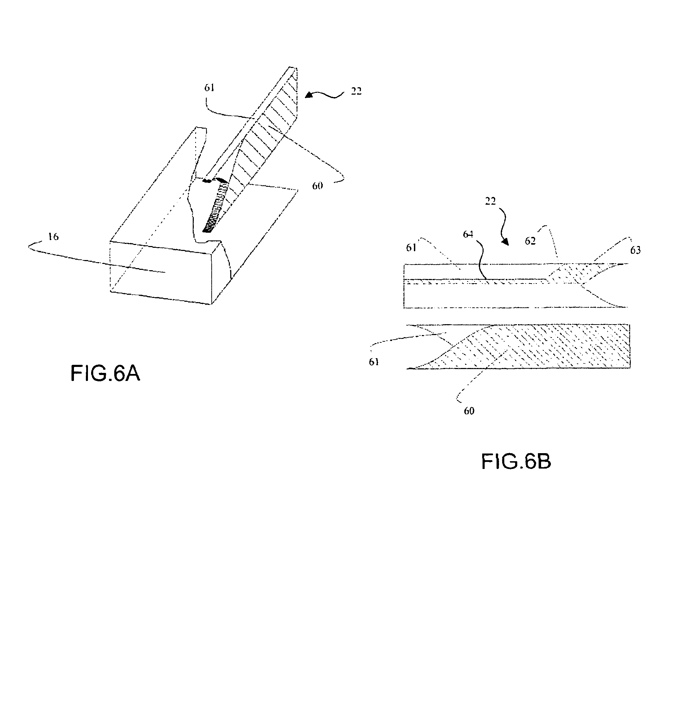

Les voies amplificatrices du dispositif selon l'invention permettent d'amplifier un signal capté par des transitions 22 et de les réinjecter après amplification dans les guides d'onde rectangulaires 16 par l'intermédiaire de transitions 23. Ces transitions présentent des caractéristiques avantageuses dans le dispositif selon l'invention et peuvent être réalisées, par exemple, selon les figures 6A et 6B.

La transition du guide d'onde rectangulaire 16 vers une ligne micro-ruban 64, représentée sur les figures 6A et 6B par différentes vues, est composée de circuits placés à l'intérieur d'un guide d'onde rectangulaire et parallèlement à la propagation du champ électrique du mode dominant. Le support de ce circuit est un substrat 61 de permittivité quelconque sur lequel sont gravés de part et d'autre un plan métallique 60 et une ligne métallique 63. Le plan métallique 60 est tracé en forme de cosinus de pente nulle à l'extrémité de la transition 22 côté guide d'onde rectangulaire 16. La hauteur du cosinus correspond à la hauteur du guide d'onde rectangulaire 16 et sa longueur est à déterminer par optimisation. La ligne métallique 63 tracée sur l'autre face comporte, elle aussi, une partie en cosinus. La longueur de cette dernière partie est aussi déterminée par optimisation. Les paramètres, notamment la « période » et la « hauteur », utilisés pour tracer les cosinus du plan métallique 60 et de la ligne métallique 63 sont les mêmes. Le segment 62 reliant la ligne micro-ruban 64 à la partie haute de la transition 22 est réalisé en ligne droite mais peut cependant être réalisée en arc de cercle, cosinus ou autre. La position de la ligne ainsi que les valeurs géométriques de ce segment 62 sont à déterminer par optimisation. La découpe du substrat 61 est réalisée en suivant les profils en cosinus de la ligne et du plan métallique 60, au plus près des métallisations.

Dans un cas de réalisation comprenant plusieurs circuits, les transitions peuvent être placées parallèlement les unes des autres dans un guide d'onde rectangulaire pour réaliser une transition d'un guide d'onde 16 vers plusieurs lignes micro-rubans.

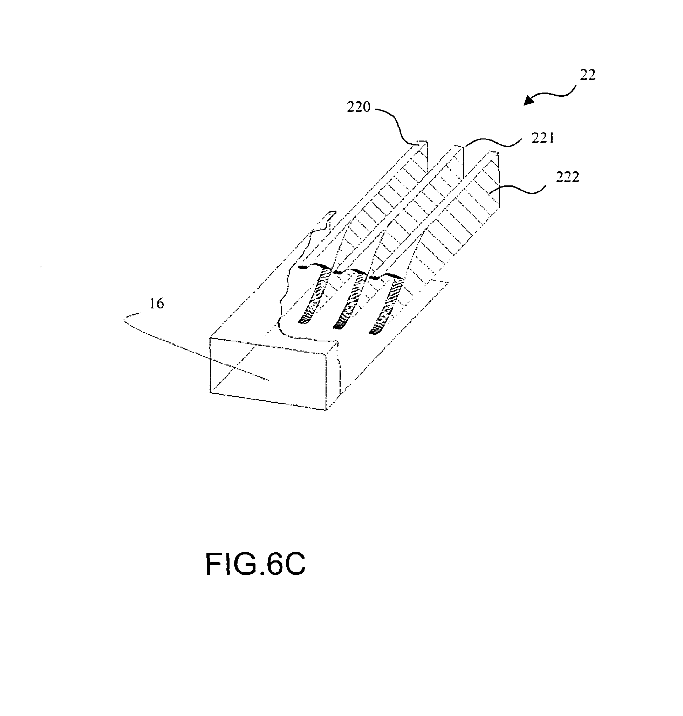

La figure 6C représente un cas d'une transition de trois lignes micro-rubans vers un guide d'onde rectangulaire composée de trois circuits 220, 221 et 222 positionnées parallèlement.

Ce type de transition permet :
■ de passer directement du mode de propagation en guide d'onde rectangulaire à un mode de propagation de type micro-ruban ;
■ de minimiser les pertes par la suppression d'une transition intermédiaire et ainsi de permettre une réduction de la complexité de réalisation ;
■ d'obtenir un encombrement réduit grâce à l'utilisation de profils en cosinus sur la ligne et le plan métallique ayant une pente nulle à l'extrémité de la transition côté guide d'onde rectangulaire ;
■ d'obtenir une large bande passante ainsi qu'un bon niveau d'adaptation ;
■ d'obtenir un coefficient de réflexion très faible en entrée de la structure, vu du guide d'onde rectangulaire, même lorsque plusieurs circuits sont présents dans le guide d'onde.

L'incorporation de cette structure dans le combineur complet permet :
■ de réduire son encombrement ;
■ de maximiser ses performances.

## Revendications

1. Système de combinaison de puissance radiale à compensation de dispersion de phase dans le domaine des hyperfréquences comprenant :
■ un premier guide d'onde radial (10), appelé diviseur radial, ayant une entrée en son centre et une pluralité de sorties en périphérie, chacune des sorties étant un guide d'onde métallique (16), le premier guide d'onde radial (10) permettant de diviser un signal d'entrée en plusieurs signaux de sortie ;
■ un second guide d'onde radial (10'), appelé combineur radial, superposé au diviseur radial (10) ayant une sortie en son centre et une pluralité d'entrées en périphérie, chacune des entrées étant un guide d'onde métallique (16), le second guide d'onde radial (10') permettant de combiner une pluralité de signaux d'entrée en un signal de sortie ;
■ une première transition d'entrée (11) émettant un premier signal dans le diviseur radial (10) ;
■ une seconde transition de sortie (11') captant le premier signal amplifié vers la sortie du combineur radial ;
■ une pluralité de voies amplificatrices (15), chacune comprenant :
o une troisième transition (22) d'entrée apte à coopérer avec l'un des guides d'onde métalliques (16) du diviseur radial (10) et ;
o une quatrième transition (23) de sortie apte à coopérer avec l'un des guides d'onde métalliques (16') du combineur radial (10') et ;
o au moins un amplificateur (24) solidaire de la troisième et quatrième transition (22, 23) ;
**caractérisé en ce que** le système comprend des moyens de réglages (29) du positionnement d'au moins une voie amplificatrice (15) dans les guides d'onde métalliques (16, 16').

2. Système selon la revendication 1, **caractérisé en ce que** les moyens de réglages (29) comprennent un jeu de cales.

3. Système selon l'une quelconque des revendications 1 à 2, **caractérisé en ce que** chaque voie amplificatrice comprend des moyens de fixations (25) permettant de fixer chaque voie amplificatrice (15) au combineur et au diviseur avec une cale (29).

4. Système selon la revendication 2, **caractérisé en ce que** le jeu de cales contribue au transfert thermique entre les voies amplificatrices et les guides d'onde radiaux.

5. Système selon la revendication 1, **caractérisé en ce que** des coquilles (26) revêtent les voies amplificatrices et favorisent les échanges thermiques entre les amplificateurs et l'extérieur du système.

6. Système selon l'une quelconque des revendications 1 à 5, **caractérisé en ce que** les guides d'onde métalliques des sorties du diviseur et des entrées du combineur sont droits de manière à ce que la connexion des voies amplificatrices est réalisée dans l'axe radial.

7. Système selon l'une quelconque des revendications 1 à 5, **caractérisé en ce que** les guides d'onde métalliques des sorties du diviseur et des entrées du combineur sont coudés de manière à ce que la connexion des voies amplificatrices est réalisée perpendiculairement à l'axe radial.

8. Système selon l'une quelconque des revendications 1 à 7, **caractérisé en ce que** le diviseur radial et le combineur radial comprennent des matériaux absorbants ou des moyens dissipatifs assurant l'isolation entre les voies.

9. Système selon l'une quelconque des revendications 1 à 7, **caractérisé en ce que** les guides d'onde métalliques (16, 16') en périphérie des deux guides d'ondes radiaux (10, 10') sont des guides d'onde rectangulaires.

10. Système selon l'une quelconque des revendications 1 à 9, **caractérisé en ce que** l'entrée du diviseur (28) et/ou la sortie du combineur (28') sont des guides d'onde cylindriques.

11. Système selon l'une quelconque des revendications 1 à 9, **caractérisé en ce que** l'entrée du diviseur (28) et/ou la sortie du combineur (28') sont des guides d'onde coaxiaux.

12. Système selon la revendication 11, **caractérisé en ce qu'**au moins une transition (11, 11') comporte une âme centrale (112) en contact avec la partie inférieure (103) d'un guide d'onde radial (10, 10').

13. Système selon la revendication 12, **caractérisé en ce qu'**au moins un accès d'un guide d'onde coaxial centré sur le guide d'onde radial est destiné à recevoir un connecteur coaxial (28), une bague de centrage (111), une âme centrale (112) et **en ce que** cet accès se prolonge en partie dans le guide d'onde radial (10, 10') par un conducteur extérieur (101) en forme de cône directement usiné dans le capot supérieur (100).

14. Système selon la revendication 9, **caractérisé en ce que** la transition (22, 23) entre le mode de propagation en guide d'onde rectangulaire (16) et le mode de propagation en micro-ruban (63) comprend :
■ des métallisations (63) dont le profil est en cosinus avec une pente nulle à l'extrémité de la transition côté guide d'onde rectangulaire et ;
■ un substrat (61) découpé selon le profil en cosinus des métallisations de manière à minimiser le coefficient de réflexion de la transition.

## Patentansprüche

1. System zum Kombinieren von radialer Leistung mit Phasendispersionsausgleich im Hyperfrequenzbereich, das Folgendes umfasst:
- einen ersten radialen Wellenleiter (10), radialer Teiler genannt, mit einem Eingang in seiner Mitte und mehreren Ausgängen an der Peripherie, wobei jeder der Ausgänge ein metallischer Wellenleiter (16) ist, wobei der erste radiale Wellenleiter (10) es zulässt, ein Eingangssignal in mehrere Ausgangssignale zu unterteilen;
- einen zweiten radialen Wellenleiter (10'), radialer Kombinator genannt, der über dem radialen Teiler (10) mit einem Ausgang in der Mitte und mehreren Eingängen an der Peripherie liegt, wobei jeder der Eingänge ein metallischer Wellenleiter (16) ist, wobei es der zweite radiale Wellenleiter (10') zulässt, mehrere Eingangssignale zu einem Ausgangssignal zu kombinieren;
- einen ersten Eingangsübergang (11), der ein erstes Signal in den radialen Teiler (10) aussendet;
- einen zweiten Ausgangsübergang (11'), der das erste verstärkte Signal zum Ausgang des radialen Kombinators erfasst;
- mehrere Verstärkungskanäle (15), die jeweils Folgendes umfassen:
- einen dritten Eingangsübergang (22) zum Zusammenwirken mit einem der metallischen Wellenleiter (16) des radialen Teilers (10), und
- einen vierten Ausgangsübergang (23) zum Zusammenwirken mit einem der metallischen Wellenleiter (16') des radialen Kombinators (10'), und
- wenigstens einen Verstärker (24) einstückig mit dem dritten und dem vierten Übergang (22, 23);
**dadurch gekennzeichnet, dass** das System Justiermittel (29) zum Positionieren von wenigstens einem Verstärkungskanal (15) in den metallischen Wellenleitern (16, 16') umfasst.

2. System nach Anspruch 1, **dadurch gekennzeichnet, dass** die Justiermittel (29) Beilagesätze umfassen.

3. System nach einem der Ansprüche 1 bis 2, **dadurch gekennzeichnet, dass** jeder Verstärkungskanal Befestigungsmittel (25) umfasst, mit denen jeder Verstärkungskanal (15) am Kombinator und am Teiler mit einer Beilage (29) befestigt werden kann.

4. System nach Anspruch 2, **dadurch gekennzeichnet, dass** der Beilagesatz zur Wärmeübertragung zwischen den Verstärkungskanälen und den radialen Wellenleitern beiträgt.

5. System nach Anspruch 1, **dadurch gekennzeichnet, dass** die Verstärkungskanäle mit Schalen (26) ausgelegt sind und Wärmeaustausch zwischen den Verstärkern und dem Systemäußeren begünstigen.

6. System nach einem der Ansprüche 1 bis 5, **dadurch gekennzeichnet, dass** die metallischen Wellenleiter der Ausgänge des Teilers und der Eingänge des Kombinators gerade sind, so dass die Verbindung der Verstärkungskanäle in der radialen Achse erfolgt.

7. System nach einem der Ansprüche 1 bis 5, **dadurch gekennzeichnet, dass** die metallischen Wellenleiter der Ausgänge des Teilers und der Eingänge des Kombinators gekrümmt sind, so dass die Verbindung der Verstärkungskanäle lotrecht zur radialen Achse erfolgt.

8. System nach einem der Ansprüche 1 bis 7, **dadurch gekennzeichnet, dass** der radiale Teiler und der radiale Kombinator absorptionsfähige Materialien oder ableitende Mittel umfassen, die die Isolation zwischen den Kanälen gewährleisten.

9. System nach einem der Ansprüche 1 bis 7, **dadurch gekennzeichnet, dass** die metallischen Wellenleiter (16, 16') an der Peripherie der beiden radialen Wellenleiter (10, 10') rechteckige Wellenleiter sind.

10. System nach einem der Ansprüche 1 bis 9, **dadurch gekennzeichnet, dass** der Eingang des Teilers (28) und/oder der Ausgang des Kombinators (28') zylindrische Wellenleiter sind.

11. System nach einem der Ansprüche 1 bis 9, **dadurch gekennzeichnet, dass** der Eingang des Teilers (28) und/oder der Ausgang des Kombinators (28') koaxiale Wellenleiter sind.

12. System nach Anspruch 11, **dadurch gekennzeichnet, dass** wenigstens ein Übergang (11, 11') einen zentralen Steg (112) in Kontakt mit dem unteren Teil (103) eines radialen Wellenleiters (10, 10') umfasst.

13. System nach Anspruch 12, **dadurch gekennzeichnet, dass** wenigstens ein Zugang von einem auf dem radialen Wellenleiter zentrierten koaxialen Wellenleiter so ausgelegt ist, dass er einen koaxialen Verbinder (28), einen Zentrierring (111), einen zentralen Steg (112) aufnimmt, und dadurch, dass dieser Zugang in dem radialen Wellenleiter (10, 10') durch einen direkt in den oberen Deckel (100) eingearbeiteten externen Leiter (101) in Kegelform teilweise verlängert ist.

14. System nach Anspruch 9, **dadurch gekennzeichnet, dass** der Übergang (22, 23) zwischen der Ausbreitungsmode im rechteckigen Wellenleiter (16) und der Ausbreitungsmode im Mikroband (63) Folgendes umfasst:
- Metallisierungen (63), deren Profil eine Kosinusfunktion mit einer Steigung von null am Ende des Übergangs auf der Seite des rechteckigen Welleleiters ist, und
- ein Substrat (61), das gemäß dem Profil mit Kosinusfunktion der Metallisierungen geschnitten ist, um den Reflexionskoeffizienten des Übergangs zu minimieren.

## Claims

1. Radial power combination system having phase dispersion compensation in the range of ultra-high frequencies, comprising:
● a first radial wave guide (10), referred to as a radial divider, having an input at the centre thereof and a plurality of outputs at the periphery thereof, each of the outputs being a metal wave guide (16), the first radial wave guide (10) allowing an input signal to be divided into a plurality of output signals;
● a second radial wave guide (10'), referred to as a radial combiner, which is superimposed on the radial divider (10) and which has an output at the centre thereof and a plurality of inputs at the periphery, each of the inputs being a metal wave guide (16), the second radial wave guide (10') allowing a plurality of input signals to be combined to form an output signal;
● a first input transition (11) which emits a first signal into the radial divider (10);
● a second output transition (11') which captures the first signal which is amplified towards the output of the radial combiner;
● a plurality of amplifier channels (15), each comprising:
● a third input transition (22) which is capable of co-operating with one of the metal wave guides (16) of the radial divider (10) and;
● a fourth output transition (23) which is capable of co-operating with one of the metal wave guides (16') of the radial combiner (10') and;
● at least one amplifier (24) which is fixedly joined to the third and fourth transition (22, 23);
**characterised in that** the system comprises means (29) for controlling the positioning of at least one amplifier channel (15) in the metal wave guides (16, 16').

2. System according to claim 1, **characterised in that** the control means (29) comprise a set of wedges.

3. System according to either claim 1 or claim 2, **characterised in that** each amplifier channel comprises fixing means (25) which allow each amplifier channel (15) to be fixed to the combiner and divider with a wedge (29).

4. System according to claim 2, **characterised in that** the set of wedges contributes to the thermal transfer between the amplifier channels and the radial wave guides.

5. System according to claim 1, **characterised in that** shells (26) cover the amplifier channels and promote the thermal exchanges between the amplifiers and the outer side of the system.

6. System according to any one of claims 1 to 5, **characterised in that** the metal wave guides of the outputs of the divider and the inputs of the combiner are straight so that the connection of the amplification channels is produced in the radial axis.

7. System according to any one of claims 1 to 5, **characterised in that** the metal wave guides of the outputs of the divider and the inputs of the combiner are bent so that the connection of the amplification channels is produced perpendicularly relative to the radial axis.

8. System according to any one of claims 1 to 7, **characterised in that** the radial divider and the radial combiner comprise absorbent materials or dissipating means which ensure the insulation between the channels.

9. System according to any one of claims 1 to 7, **characterised in that** the metal wave guides (16, 16') at the periphery of the two radial wave guides (10, 10') are rectangular wave guides.

10. System according to any one of claims 1 to 9, **characterised in that** the input of the divider (28) and/or the output of the combiner (28') are cylindrical wave guides.

11. System according to any one of claims 1 to 9, **characterised in that** the input of the divider (28) and/or the output of the combiner (28') is/are coaxial wave guides.

12. System according to claim 11, **characterised in that** at least one transition (11, 11') comprises a central core (112) which is in contact with the lower portion (103) of a radial wave guide (10, 10').

13. System according to claim 12, **characterised in that** at least one access of a coaxial wave guide centred on the radial wave guide is intended to receive a coaxial connector (28), a centering ring (111), a central core (112) and **in that** this access partially extends in the radial wave guide (10, 10') via an outer conductor (101) in the form of a cone which is directly constructed in the upper hood (100).

14. System according to claim 9, **characterised in that** the transition (22, 23) between the rectangular wave guide (16) propagation mode and the micro-strip (63) propagation mode comprises:
● electroplatings (63) whose profile is cosinusoidal with a zero gradient at the end of the transition at the side of the rectangular wave guide and;
● a substrate (61) which is cut in accordance with the cosinusoidal profile of the electroplatings so as to minimise the reflection coefficient of the transition.
